Europäisches Patentamt

European Patent Office

Office européen des brevets

(11) Veröffentlichungsnummer: **0 268 929**
**A2**

## (12) EUROPÄISCHE PATENTANMELDUNG

(21) Anmeldenummer: 87116596.5

(22) Anmeldetag: 10.11.87

(51) Int. Cl.⁴: **H03M 1/36**

(30) Priorität: 12.11.86 DE 3638556

(43) Veröffentlichungstag der Anmeldung:
**01.06.88 Patentblatt 88/22**

(84) Benannte Vertragsstaaten:
**AT BE DE ES FR GB IT NL**

(71) Anmelder: **Werba, Hans**
**Theresienstrasse 11**
**D-8390 Passau(DE)**

(72) Erfinder: **Werba, Hans**
**Theresienstrasse 11**
**D-8390 Passau(DE)**

(74) Vertreter: **Klunker . Schmitt-Nilson . Hirsch**
**Winzererstrasse 106**
**D-8000 München 40(DE)**

(54) **Analog/Digital-Wandlerschaltung mit Widerstands-Paar.**

(57) Bei einer Analog/Digital-Wandlerschaltung bilden die Knoten an mehreren Widerständen einer Spannungsteilerkette Bezugsspannungsknoten. Die Bezugsspannungen werden mit der von einer Analogsignalquelle abgegebenen Analogspannung verglichen. Anstelle der früher üblichen, aus Operationsverstärkern gebildeten Vergleicher wird zwischen jeweils einem eine bestimmte Bezugsspannung abgebenden Schaltungsknoten und der Analogsignalquelle ein Widerstands-Paar mit zwei identischen Widerständen vorgesehen, um an dem Verbindungsknoten der beiden Widerstände ein "0"-Signal abgreifen zu können. Die Spannungsteilerkette liegt zwischen einer negativen Spannung von beispielsweise -4 V und Masse (0 V), während das Analogsignal einen Wert zwischen 0 V und 4 V annehmen kann. An derjenigen Stelle, an der das positive Analogsignal im wesentlichen die gleiche Amplitude hat wie die negative Bezugsspannung, beträgt die Spannung, zwischen den Widerständen des Widerstands-Paares etwa 0 V. Bei einem getakteten Wandler ist jedem Verbindungsknoten zwischen den Widerständen eine Filter/Verstärker-Schaltung nachgeordnet, die aufgrund ihrer Tiefpass-Kennlinie eine Abflachung des jeweiligen Signalausschnitts bewirkt.

FIG. 1

## Analog/Digital-Wandlerschaltung mit Widerstands-Paar

Die Erfindung betrifft eine Analog/Digital-Wandlerschaltung nach dem Oberbegriff des Anspruchs 1.

Solche Analog/Digital-Wandlerschaltungen wurden von dem Anmelder bereits in verschiedenen Ausführungsformen vorgeschlagen(z.B. DE-OS 34 25 399). Diese Schaltungen haben sich bewährt, bei hohen Frequenzen treten jedoch bestimmte Nachteile auf. Die Vergleichsschaltungen bei den bekannten Analog/Digital-Wandlern der hier in Rede stehenden Art sind als herkömmliche Vergleicher (Komparatoren) mit Hilfe von Operationsverstärkern ausgebildet. Als nachteilig bei solchen herkömmlichen Vergleichern hat sich jedoch die Zeitverzögerung erwiesen, die zum Durchschalten des Signals vom Eingang zum Ausgang des Vergleichers benötigt wird.

Bei den meisten bekannten Analog/Digital-Wandlern wird eine Vielzahl von Bezugsspannungen mit einem zu wandelnden Analogsignal verglichen, wobei Vergleichsspannungen und Analogspannung gleiche Polarität haben.

Der Erfindung liegt die Aufgabe zugrunde, eine Analog/Digital-Wandlerschaltung zu schaffen, die ohne die bekannten Vergleicher auskommt und somit eine raschere Signalverarbeitung ermöglicht.

Die Aufgabe wird durch die im Kennzeichnungsteil des Anspruchs 1 angegebene Maßnahme gelöst.

Der erfindungsgemäße Wandler beruht auf folgender Überlegung: Wenn man mit Hilfe einer Spannungsteilerkette abgestufte Bezugsspannungen einer bestimmten Polarität, z. B. negative Bezugsspannungen erzeugt, während das zu wandelnde Signal die andere Polarität, z. B. positive Polarität besitzt, existiert in der Reihe von "Vergleichsschaltungen" zumindest eine Stelle, bei der die jeweils miteinander verglichenen Spannungen entgegengesetztes Vorzeichen, aber im wesentlichen gleiche Amplitude besitzen. An dieser Stelle liegt zwischen den beiden Widerständen etwa die Spannung 0 vor. Mit Hilfe dieses "0"-Signals läßt sich in an sich bekannter Weise ein BCD-Code-Signal erzeugen, welches dem Analogsignal entspricht.

Die Umwandlung eines Analogsignals erfolgt in der Regel nach Maßnahme eines Taktes. In anderen Worten: Innerhalb einer sehr kurzen Zeitspanne wird ein Signalausschnitt aus dem umzuwandelnden Signal herausgegriffen, und dieser Ausschnitt wird der Analog/Digital-Wandlung zugrunde gelegt. Wenn sich das Analogsignal nur sehr langsam ändert, ist die Amplitude des Signalausschnitts praktisch horizontal. Anders bei sich rasch ändernden Analogsignalen: Je nach dem, ob das Signal im Intervall des Signalausschnitts gerade steil ansteigt oder abfällt, kann zwischen der Amplitude am Anfang des Signalausschnitts und der Amplitude am Ende des Signalausschnitts eine Amplitudendifferenz in der Größenordnung von einem Volt vorhanden sein.

Definiert man die Mitte eines Signalausschnitts als den maßgeblichen Zeitpunkt, so ist der durch die Wandlung ermittelte Digitalwert nicht genau; denn in der Regel wird der Signalwert nicht der Amplitude des Signalausschnitts in der Mitte des Ausschnitts entsprechen, sondern der Amplitude am Ende des Signalausschnitts. Da sich innerhalb eines Signalausschnitts die Amplitude des umzuwandelnden Signals möglicherweise um mehr als der Differenz zweier benachbarter Bezugsspannungswerte ändert, ist das gewonnene Digitalsignal derart fehlerbehaftet, daß die niedrigstwertigen Stellen des Digitalsignals unmaßgeblich sind.

Um die Genauigkeit und mithin das Auflösungsvermögen des Analog/Digital-Wandlers zu erhöhen, sind erfindungsgemäß an die einzelnen Verbindungsknoten zwischen zwei Widerständen eines Widerstands-Paares Filter/Verstärker-Schaltungen angeschlossen. In diesen Schaltungen ist jeweils eine einem Vorwiderstand nachgeschaltete Parallelschaltung aus einer Diode und einer Kapazität vorgesehen, die zwischen dem Verbindungsknoten und Masse liegt, außerdem eine Verstärkerschaltung, die an die Kapazität angeschlossen ist. Mehrere derartige Filter/Verstärker-Schaltungen können in Kaskade geschaltet sein. Am Ausgang der Filter/Verstärker-Schaltung ergibt sich aufgrund der Tiefpaß-Charakteristik der Schaltung ein Signal, welches innerhalb des gesamten Intervalls eines Analogsignalausschnitts im wesentlichen eine konstante Amplitude hat. An derjenigen Stelle des Wandlers, an der zwischen den beiden Widerständen die Spannung um 0 erzeugt wird (Auslöschung der verglichenen Spannungen), bewirkt die erfindungsgemäße Filter/Verstärker-Schaltung eine Glättung. Diese Glättung hat die Folge, daß praktisch in dem gesamten Intervall des Signalausschnitts eine Spannung von "0" erhalten wird.

Bei einem Analog/Digital-Wandler mit einem Taktgeber sind an verschiedenen Stellen des Wandlers Schalter vorgesehen, um das Analogsignal nur in bestimmten Zeitintervallen zu wandeln. Die betätigten Schalter bewirken also die Erzeugung eines Signalausschnitts des zu wandelnden Analogsignals.

Bei den Schaltern kann es sich beispielsweise um Feldeffekttransistoren handeln. Zum Zwecke der Entkopplung kann jedem Widerstand des Widerstands-Paares ein Transistor vorgeschaltet sein.

Vorzugsweise befindet sich der Schalter in jeder Stufe des Wandlers zwischen dem jeweiligen Verbindungsknoten und der nachgeordneten Filter/Verstärker-Schaltung. Alternativ dazu können die Schalter auch an den Anschlüssen der beiden Widerstände des Widerstands-Paares vorgesehen sein, die dem Verbindungsknoten zwischen den beiden Widerständen abgewandt sind. Eine andere Möglichkeit besteht darin, der Spannungsteilerkette einen Schalter zuzuordnen, mit dessen Hilfe sämtliche Stufen des Wandlers auf der Seite der Bezugsspannungsquellen aktiviert werden. Dementsprechend ist der Analogsignalquelle dann ein einziger Schalter nachgeordnet.

Man kann die beiden oben genannten Möglichkeiten auch kombinieren, d.h.: Es kann der Spannungsteilerkette ein einziger Schalter vorgeschaltet sein, während jedem Widerstand des Widerstands-Paares, der der Analogsignalquelle zugeordnet ist, ein separater Schalter vorgeschaltet ist.

Im folgenden wird ein Ausführungsbeispiel der Erfindung anhand der Zeichnung näher erläutert. Es zeigen:

Fig. 1 eine schematische Schaltungssskizze einer Analog/Digital-Wandlerschaltung mit n-Stufen,

Fig. 2 eine Skizze einer Filter/Verstärker-Schaltung, wie sie in jeder Stufe des Wandlers nach Fig. 1 vorgesehen ist,

Fig. 3 ein Wellenform-Diagramm, welches veranschaulicht, wie einzelne Signalausschnitte für die Analog/Digital-Umsetzung aus einem Analogsignal herausgegriffen werden,

Fig. 4 eine Einzelheit eines Signalausschnitts vor bzw. nach der Filterung und Verstärkung,

Fig. 5 eine Skizze, die verschiedene Möglichkeiten der Anordnung von Schaltern in dem Analog/Digital-Wandler veranschaulicht, und

Fig. 6 eine Skizze, die die Anordnung von Entkopplungs-Transistoren zu den Widerständen jeder Stufe des Wandlers veranschaulicht.

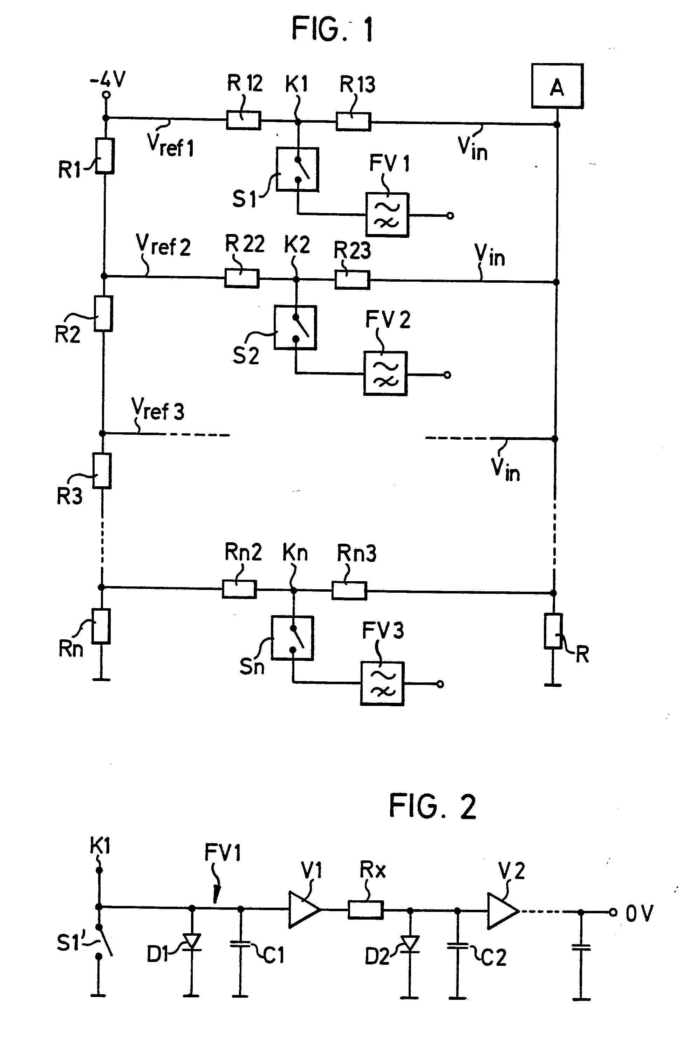

Nach Fig. 1 liegt zwischen einem Versorgungsspannungsanschluß von -4 V und Schaltungsmasse eine aus n-Widerständen R1, R2, ... Rn bestehende Spannungsteilerkette. Eine Analogsignalquelle A ist über einen Abschlußwiderstand R auf Masse gelegt.

Der obere Anschluß jedes Widerstands R1, R2, ... bildet einen Schaltungsknoten, der eine Bezugsspannung $V_{ref1}$, $V_{ref2}$, ... bereitstellt. Zwischen den einzelnen Schaltungsknoten für die einzelnen Bezugsspannungen und der Analogsignalquelle A liegen n Stufen des Analog/Digital-Wandlers. Jede Stufe besitzt eine Spannungs-Vergleichsschaltung und eine daran über einen Schalter angeschlossene Filter/Verstärker-Schaltung.

Da die einzelnen Stufen des Wandlers identisch ausgebildet sind, soll hier stellvertretend nur die Stufe 2 beschrieben werden. Zwischen dem Schaltungsknoten, der die Bezugsspannung $V_{ref2}$ erzeugt, und der Analogsignalquelle A liegt ein Wider stands-Paar, bestehend aus identischen Widerständen R22 und R23, die zwischen sich einen Verbindungsknoten K2 bilden. Dem Widerstand R22 wird die Bezugsspannung $V_{ref2}$ zugeführt, dem Widerstand R23 wird von der Analogsignalquelle A die umzuwandelnde Eingangs-oder Analogspannung $V_{ln}$ zugeführt.

An den Verbindungsknoten K2 ist ein hier als Schließer dargestellter Schalter S2 angeschlossen, bei dem es sich z. B. um einen Feldeffekttransistor handelt. Der Schalter S2 wird gleichzeitig mit den entsprechenden Schaltern S1 bis Sn des Wandlers geschlossen, wenn ein Analogsignal in einen Digitalwert umgesetzt werden soll.

An den Schalter S2 ist eine Filter/Verstärker-Schaltung 2 angeschlossen.

Die in Fig. 1 dargestellte Anordnung stellt das bevorzugte Ausführungsbeispiel der Erfindung dar. Die einzelnen Schaltungsknoten der Spannungsteilerkette geben dauernd die Bezugssignale ab. An jeden einzelnen Verbindungsknoten K1, K2, ... ist ein Schalter S1, S2, ... angeschlossen. Während die negative Spannung -4 V beträgt, kann sich das umzusetzende Analogsignal zwischen 0 V (Masse) und +4 V bewegen. Selbstverständlich sind andere Spannungsbereiche möglich.

Es sei nun angenommen, die Analogsignalquelle gebe zu einem Zeitpunkt, zu dem die Schalter S1, S2, ... geschlossen werden, eine Spannung von 3 V ab. Zur Vereinfachung sei außerdem angenommen, die Spannungsteilerkette beinhalte vier identische Widerstände. Dann beträgt die Bezugs spannung $V_{ref2}$ -3 V. Am Knoten K2 entsteht dadurch eine "Auslöschung", d.h. eine Spannung von etwa 0 V. Dieses "0"-Signal läßt sich in an sich bekannter Weise in einen BCD-Code umsetzen.

Die nach unten anschließenden Stufen des Wandlers geben an ihren Knoten ein positives Signal ab, welches aber durch die Filter/Verstärker-Schaltung auf Massepotential gezogen wird. Dementsprechend geben sämtliche Stufen unterhalb derjenigen Stufe, die das "0"-Signal erzeugt, ebenfalls ein "0"-Signal ab, während die darüberliegenden Stufen des Wandlers ein "1"-Signal erzeugen.

Fig. 2 zeigt stellvertretend für jede der Filter/Verstärker-Schaltungen FV1, FV2, ... die in der ersten Stufe vorgesehene Filter/Verstärker-Schaltung FV1. Die Filter/Verstärker-Schaltung nach Fig. 2 ist an den Schalter angeschlossen, der hier den Verbindungsknoten K1 mit Masse verbindet. Der Schalter S1' ist hier als Öffner ausgebildet. Soll ein Signal abgegriffen werden, so wird der Schalter geöffnet, so daß das Signal von dem Knoten K1 auf die Filterschaltung gelangt.

Einem Verstärker V1, bei dem es sich z. B. um einen Transistor handelt, sind eine Diode D1 und eine Kapazität C1 in Parallelschaltung vorgeschaltet. Als Vorwiderstand dient hier das Widerstands-Paar R12, R13 (Fig. 1). Je nach Anwendungsfall reicht die oben beschriebene Filterschaltung aus. Es können aber auch mehrere derartige Filterschaltungen in Kaskade hintereinander geschaltet werden, wie dies in Fig. 2 gezeigt ist. Dabei ist an den Ausgang des Verstärkers V1 ein Vorwiderstand Rx geschaltet. Daran schließen sich eine Diode D2, eine Kapazität C2 und ein zweiter Verstärker V2 an. Mehrere solcher Filter/Verstärker-Schaltungen können sich anschließen, so daß am Ausgang ein geglättetes Signal von 0 V entsteht.

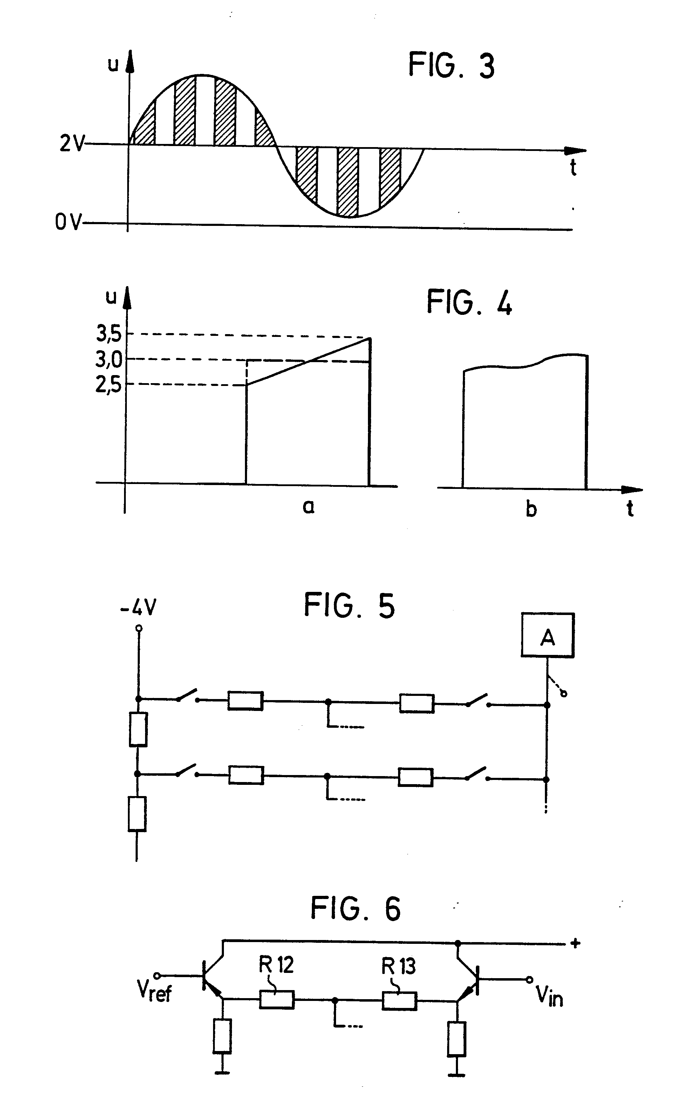

Fig. 3 zeigt den etwa sinusförmigen Verlauf einer umzusetzenden Analogspannung Die schraffierten Bereiche zeigen die Signalausschnitte. In den einzelnen Intervallen der Signalausschnitte muß das Analogsignal in einen entsprechenden Digitalwert umgesetzt werden. Es ist ersichtlich, daß bei sich rasch ändernden Signalamplituden Ungenauigkeiten bei der Umsetzung entstehen können, da die Amplitude zu Beginn des jeweiligen Signalausschnitts wesentlich niedriger oder wesentlich höher ist als am Ende des Signalausschnitts.

Dies ist in Fig. 4 näher dargestellt. Bei einer Anfangsamplitude von 2,5 V beginnt der Signalausschnitt gemäß Fig. 4a), um am Ende des Signalausschnitts einen Wert von etwa 3,5 V anzunehmen. Der Mittelwert beträgt etwa 3,0 V. Durch die in Fig. 2 dargestellte Filterschaltung, die Tiefpass-Charakteristik besitzt, wird der schräge Verlauf der Amplitude des Signalausschnitts geglättet (Fig. 4b)). An der Filterschaltung erscheint dabei nur das Differenzsignal, d.h. ein Signal, das zwischen -0,5 V und +0,5 V ansteigt.

Die aufeinanderfolgenden Signalausschnitte werden durch einen hier nicht dargestellten Taktgeber erzeugt. Der Taktgeber erzeugt ein Taktsignal, welches das Öffnen und Schließen von Schaltern für die Signalumsetzung steuert.

Fig. 5 zeigt schematisch die mögliche Anordnung der Schalter. Die optimale Anordnung der Schalter ist - wie gesagt - in Fig. 1 gezeigt.Demnach befindet sich jeweils ein Schalter zwischen einem Verbindungsknoten K1, K2, ... und der nachge ordneten Filter/Verstärker-Schaltung VF1, VF2, ... . In einer ersten alternativen Ausführungsform kann jedem Widerstand des Widerstands-Paares R12, R13, ... ein Schalter zugeordnet sein, wie es in Fig. 5 durch ausgezogene Linien angedeutet ist. Dazu alternativ können die Schalter in jeder Stufe auf der linken Seite (also dort, wo die Bezugsspannungen anstehen) ersetzt werden durch einen einzigen Schalter zwischen dem obersten Widerstand R1 der Spannungsteilerkette und der Spannungsquelle - 4V. Auch die Schalter in den einzelnen Stufen auf der rechten Seite können ersetzt werden durch einen einzigen Schalter, der der Analogsignalquelle A direkt nachgeordnet ist. Dieser Schalter ist in Fig. 5 gestrichelt dargestellt.

Der Vollständigkeit halber sei hier erwähnt, daß jedem Widerstand des Widerstands-Paares in jeder Stufe des Analog/Digital-Wandlers ein Entkopplungs-Transistor zugeordnet sein kann. Gemäß Fig. 6 sind ein PNP-und ein NPN-Transistor vorgesehen, deren Basen die Bezugsspannung $V_{ref}$ bzw. die zu wandelnde Analogspannung $V_{in}$ zugeführt werden. Die Kollektoren sind an eine positive Spannungsquelle angeschlossen. Die Emitter liegen über Emitterwiderstände auf Masse.

## Ansprüche

1. Analog/Digital-Wandlerschaltung, mit
-einer Spannungsteilerkette (R1, R2, ...), die eine bestimmte Anzahl von Bezugsspannungen ($V_{ref1}$ , ...) an einzelnen Schaltungsknoten erzeugt,
-einer Analogsignalquelle (A), und
-einer Reihe von Amplitudenvergleichsschaltungen zwischen der Analogsignalquelle und den einzelnen Schaltungsknoten der Spannungsteilerkette, die die verschiedenen Bezugsspannungen ($V_{ref1}$, $V_{ref2}$, ...) zu dem Analogsignal in Beziehung setzen, und von denen mindestens diejenige Vergleichsschaltung ein "0"-Signal abgibt, bei der zumindest näherungsweise eine Übereinstimmung zwischen Bezugsspannung und Analogsignal vorliegt,
dadurch **gekennzeichnet,**
daß die Vergleichsschaltungen jeweils aus einem Paar von identischen Widerständen (R12, R13; R22, R23, ...) bestehen, an deren Verbindungsknoten ein bei Übereinstimmung zwischen Analogsignal und jeweiliger Bezugsspannung "0"-Signal abgreifbar ist.

2. Schaltung nach Anspruch 1,
dadurch gekennzeichnet,
daß an dem Verbindungsknoten (K1, K2, ...) eine Filter/Verstärker-Schaltung (FV1, FV2, ...) angeschlossen ist.

3. Schaltung nach Anspruch 2,
dadurch gekennzeichnet,
daß jede Filter/Verstärker-Schaltung aufweist:
-eine einem Vorwiderstand (Rx) nachgeschaltete Parallelschaltung aus einer Diode (D1, D2) und einer Kapazität (C1, C2, ...), die zwischen dem Verbindungsknoten (K1, K2, ...) und Masse liegt, und

    -eine Verstärkerschaltung (V1; V2), die an die Kapazität (C1; C2) angeschlossen ist.

    4. Schaltung nach Anspruch 3,
dadurch gekennzeichnet,
daß mehrere Filter/Verstärker-Schaltungen hintereinander geschaltet sind.

    5. Schaltung nach einem der Ansprüche 1 bis 4,
dadurch gekennzeichnet,
daß bei einem Analogsignal zwischen 0 V und +X V die Spannungsteilerkette (R1, R2, ...) zwischen -X V und 0 V (Masse) liegt.

    6. Schaltung nach einem der Ansprüche 1 bis 5, bei dem ein Taktgeber vorgesehen ist,
dadurch gekennzeichnet,
daß jedem Verbindungsknoten (K1, K2, ...) ein Schalter (S1, ...) nachgeordnet ist, der nach Maßgabe des von dem Taktgeber erzeugten Taktsignals betätigt wird.

    7. Schaltung nach Anspruch 6,
dadurch gekennzeichnet,
daß der Schalter (S1) ein Schließer ist.

    8. Schaltung nach Anspruch 6,
dadurch gekennzeichnet,
daß der Schalter ein Öffner (S1') ist, und daß das "0"-Signal zwischen dem Öffner und dem Verbindungsknoten (K1, K2, ...) abgreifbar ist.

    9. Schaltung nach einem der Ansprüche 1 bis 5, bei dem ein Taktgeber vorgesehen ist,
dadurch gekennzeichnet,
daß ein Schalter jeweils

    a) vor dem obersten Schaltungsknoten der Spannungsteilerkette und direkt der Analogsignalquelle nachgeschaltet vorgesehen ist, oder

    b) vor dem obersten Schaltungsknoten der Spannungsteilerkette und zwischen der Analogsignalquelle (A) und jedem daran angeschlossenen Widerstand (R13, R23, ...) des Widerstands-Paares, oder

    c) an dem dem jeweiligen Verbindungsknoten (K1, K2, ...) abgewandten Anschluß der Widerstände des Widerstands-Paares
angeordnet ist.

# FIG. 1

# FIG. 2

FIG. 3

FIG. 4

FIG. 5

-4V

A

FIG. 6

$V_{ref}$

R 12

R 13

$V_{in}$

+